# FASCICULE DE BREVET EUROPEEN

(11) **EP 4 701 373 B1**
(45) Date de publication et mention de la délivrance du brevet: **12.08.2026**
(21) Numéro de dépôt: 25196325.2
(22) Date de dépôt: 18.08.2025
(51) Int. Cl.: H10F 71/00, B23K 26/08

(54) **DISPOSITIF D'INTERCONNEXION DE CELLULES PHOTOVOLTAÏQUES**
VORRICHTUNG ZUR VERBINDUNG VON PHOTOVOLTAISCHEN ZELLEN
DEVICE FOR INTERCONNECTING PHOTOVOLTAIC CELLS

(30) Priorité: 19.08.2024 FR 2408963
(43) Date de publication de la demande: 25.02.2026
(73) Titulaire: Commissariat à l'Energie Atomique et aux Energies Alternatives, 75015 Paris (FR)
(72) Inventeur: BARTH, Vincent, 38054 GRENOBLE CEDEX 09 (FR); JERONIMO, Pedro, 38054 GRENOBLE CEDEX 09 (FR)
(74) Mandataire: Regimbeau

(56) Documents cités:
- CN-A- 103 692 086
- CN-A- 113 843 502

## Description

### DOMAINE TECHNIQUE DE L'INVENTION

La présente invention se rapporte au domaine général des modules photovoltaïques, qui comportent un ensemble de cellules photovoltaïques reliées entre elles électriquement, et préférentiellement des cellules photovoltaïques dites « cristallines », c'est-à-dire qui sont à base de silicium monocristallin ou multicristallin, de matériaux III-V, de couches minces (CIGS, CdTe, pérovskites, etc.) ou toute combinaison de ces différents matériaux.

En particulier, elle concerne les cellules photovoltaïques de type tandem combinant le silicium et un matériau pérovskite, les cellules photovoltaïques homojonction ou hétérojonction à base de silicium monocristallin (c-Si) et/ou multi-cristallin (mc-Si), , les cellules photovoltaïques comprenant au moins un matériau parmi le silicium amorphe (a-Si), le silicium microcristallin (µC-Si), le tellurure de cadmium (CdTe), le cuivre-indium séléniure (CIS), le cuivre-indium/gallium diséléniure (CIGS), et les pérovskites, entre autres.

Plus précisément, l'invention se rapporte au domaine de l'interconnexion des cellules photovoltaïques qui permet la formation de chaînes ou séries (ou encore « strings » en anglais) de cellules photovoltaïques, et elle concerne en particulier les équipements et procédés mis en œuvre lors de la soudure réalisée pour l'interconnexion.

Elle concerne ainsi le domaine des modules photovoltaïques utilisés pour des applications spatiales mais aussi pour des applications terrestres, et également pour des applications de type mobilité électronique, ballons ou drones, entre autres. De manière plus générale, l'invention s'applique aux applications photovoltaïques pour lesquelles la problématique d'interconnexion de cellules photovoltaïques est pertinente.

L'invention concerne ainsi un dispositif d'interconnexion de cellules photovoltaïques, ainsi qu'un procédé d'interconnexion de cellules photovoltaïques mis en œuvre au moyen d'un tel dispositif.

### ÉTAT DE LA TECHNIQUE

Un module photovoltaïque terrestre est classiquement constitué de cellules photovoltaïques électriquement connectées entre elles, généralement en série, et encapsulées dans un empilement de matériaux de type polymère et/ou verre. Cet empilement permet de protéger les cellules photovoltaïques de l'environnement extérieur, comme par exemple de la pluie, du vent, de la neige, de l'humidité, des rayonnements ultraviolets, des radiations, des chocs thermiques, entre autres, tout en conservant la fonction de conversion photoélectrique.

Ainsi, classiquement, un module photovoltaïque terrestre forme un empilement comportant successivement: un élément de protection arrière appelé « backsheet » en anglais, transparent ou non, comme par exemple une plaque de verre ou un film polymère ; un premier film encapsulant polymère ; des cellules photovoltaïques reliées électriquement entre elles, typiquement par des interconnecteurs, le plus souvent des rubans de cuivre étamé ; un deuxième film encapsulant polymère ; un élément de protection avant appelé « frontsheet » en anglais, transparent, comme par exemple une plaque de verre ou un film polymère.

L'élément de protection avant est destiné à transmettre le rayonnement solaire aux cellules photovoltaïques pour générer de l'électricité, tout en les protégeant des contraintes de l'environnement. Cet empilement est ensuite solidarisé lors d'une étape de lamination à chaud, typiquement entre 100 et 150°C, pour faire fondre les films encapsulant et provoquer la réticulation des polymères, d'où il résulte la formation d'une enveloppe d'encapsulation solide des cellules photovoltaïques collée aux éléments de protection avant et arrière.

L'interconnexion des cellules photovoltaïques est nécessaire pour pouvoir extraire le courant électrique généré par les cellules en limitant la résistance. Elle doit être résiliente pour conserver les performances et éviter les incidents potentiellement catastrophiques, comme les incendies. L'article « A review of interconnection technologies for improved crystalline silicon solar cell photovoltaic module assembly », Musa T. Zarmai et al., School of Engineering, Faculty of Science and Engineering, University of Wolverhampton, Applied Energy 154, 173-182, 15 septembre 2015, présente par exemple différentes approches connues d'interconnexion des cellules photovoltaïques dans le domaine du photovoltaïque terrestre.

Pour les modules photovoltaïques terrestres, les interconnecteurs sont classiquement des rubans ou fils de cuivre avec un revêtement argent (Ag) ou étain (Sn). La connexion électrique entre rubans/fils et cellules est assurée, dans la grande majorité des cas, sans fusion des métaux de base, par brasage avec un métal d'apport, ce qui permet d'obtenir de bons contacts ohmiques à des températures inférieures à 400°C. Dans un dispositif d'interconnexion mettant en œuvre le brasage pour réaliser l'interconnexion, les rubans ou fils sont généralement placés sur les faces avant et arrière des cellules photovoltaïques, puis un brasage simultané des faces avant et arrière est réalisé par chauffage pour éviter le fléchissement (ou « bowing » en anglais). Un masque de maintien des rubans/fils sur les cellules photovoltaïques peut être utilisé pour maintenir le contact des rubans/fils sur des plots métalliques, notamment des plots d'argent.

Dans le domaine spatial, l'interconnexion par brasage n'est pas recommandée. En effet, aux températures d'utilisation du spatial inférieures à -40°C, l'étain passe de sa forme B à sa forme α et ce changement s'accompagne d'une modification de volume et d'une fragilisation du matériau avec la présence de fissures (« embrittlement » en anglais). Ce phénomène est appelé « peste de l'étain ».

Une autre approche, à la fois valable pour le terrestre et le spatial, consiste à utiliser une soudure, avec ou sans métal d'apport et qui implique la fusion des métaux de base, notamment l'argent, le cuivre et l'aluminium. Pour des températures basses, de l'ordre de 100°C, des colles conductrices, souvent constituées de particules métalliques, notamment d'argent, dans une matrice polymère peuvent être utilisées. Pour des températures localement élevées, par exemple supérieures à 600°C, typiquement de l'ordre de 1085°C pour le cuivre, 962°C pour l'argent et 660°C pour l'aluminium, une soudure sans apport de matière peut être effectuée. Ainsi, il peut être nécessaire d'atteindre des températures qui sont trop élevées et non compatibles avec l'utilisation de certaines catégories de cellules photovoltaïques, comme les cellules photovoltaïques à hétérojonction de silicium, qui nécessitent une température de fabrication et de traitement inférieure à 200°C ou les cellules de type tandem nécessitant une température de fabrication et de traitement inférieure à 150°C, lorsque la chauffe est globale comme dans les procédés d'interconnexion par brasage.

Il existe donc un besoin pour obtenir un apport d'énergie localisé afin d'atteindre les températures élevées requises par la soudure.

L'interconnexion est critique du fait de sa fonction essentielle de transport de courant. Elle doit résister aux dilatations liées aux contraintes environnementales lors de la fabrication, notamment lors de la soudure, ou lors du fonctionnement du module photovoltaïque, par exemple lors d'éclipses au cours d'orbites terrestres, et ce malgré les différences de coefficients de dilatation thermique (ou CTE pour « Coefficient of Thermal Expansion » en anglais CTE). Ainsi, l'obtention d'une solution optimale d'échauffement localisé devrait permettre de limiter les effets CTE.

Le document CN 103 692 086 A décrit un dispositif de soudure laser configuré pour la fusion locale de conducteurs de liaison positionnés sur les deux faces d'une cellule photovoltaïque, et ce à l'aide d'un mécanisme de retournement de ladite cellule photovoltaïque.

### EXPOSÉ DE L'INVENTION

L'invention a pour but de remédier au moins partiellement aux besoins mentionnés ci-dessus et aux inconvénients relatifs aux réalisations de l'art antérieur.

En particulier, l'invention vise à permettre l'interconnexion de cellules photovoltaïques en maintenant une excellente conductivité ohmique entre les cellules quelques soient les déformations appliquées, mécaniques ou thermomécaniques.

Elle vise notamment à permettre l'interconnexion par soudure pour de multiples types de cellules photovoltaïques, sans contrainte de température, tout en permettant la soudure des deux côtés des cellules photovoltaïques.

L'invention a ainsi pour objet, selon l'un de ses aspects, un dispositif d'interconnexion par soudure laser de cellules photovoltaïques pour former au moins une chaîne de cellules photovoltaïques interconnectées par des conducteurs de liaison, caractérisé en ce qu'il comporte :
- une unité de soudure laser comportant une tête laser configurée pour effectuer au moins un tir laser pour la fusion locale, ou encore fusion localisée, d'au moins un conducteur de liaison positionné sur la face avant ou la face arrière d'au moins une cellule photovoltaïque,
- une unité de retournement de ladite au moins une cellule photovoltaïque, comportant :
   - un premier organe de préhension pour la préhension de l'une de la face avant ou de la face arrière de ladite au moins une cellule photovoltaïque, le premier organe de préhension étant apte à pivoter selon un premier angle de rotation d'au moins 180°,
   - un deuxième organe de préhension pour la préhension de l'autre de la face avant ou de la face arrière de ladite au moins une cellule photovoltaïque, le deuxième organe de préhension étant mobile par rapport au premier organe de préhension.

Le dispositif d'interconnexion selon l'invention peut en outre comporter l'une ou plusieurs des caractéristiques suivantes prises isolément ou suivant toutes combinaisons techniques possibles.

L'unité de retournement peut comporter un premier moteur pour permettre la rotation du premier organe de préhension selon le premier angle de rotation.

En outre, le premier organe de préhension et le deuxième organe de préhension peuvent être montés en superposition au moins partielle l'un par rapport à l'autre sur un montant vertical de l'unité de retournement, s'étendant selon un axe vertical de préhension. Le deuxième organe de préhension peut être mobile en translation verticale par rapport au premier organe de préhension.

Le deuxième organe de préhension peut être mobile en rotation autour de l'axe vertical de préhension, notamment selon un deuxième angle de rotation d'au moins 90°.

Par ailleurs, l'unité de retournement peut comporter un deuxième moteur pour permettre la rotation du deuxième organe de préhension autour de l'axe vertical de préhension.

L'unité de soudure laser peut comporter un masque de tir laser au travers duquel la tête laser est apte à effectuer ledit au moins un tir laser. Le masque de tir laser peut être configuré pour maintenir en position ledit au moins un conducteur de liaison contre la face avant ou la face arrière de ladite au moins une cellule photovoltaïque. Le masque de tir laser peut être tel que celui décrit dans la revendication 1 de la demande de brevet français déposée sous le numéro FR2408965, et peut comporter une ou plusieurs des caractéristiques optionnelles définies dans les revendications dépendantes de cette demande, qui est incorporée ici par référence. Ainsi, le masque de tir laser peut comporter une pluralité de picots de tir laser au travers desquels au moins un tir laser est apte à être effectué pour la soudure par fusion locale d'au moins un conducteur de liaison positionné sur la face avant ou la face arrière d'au moins une cellule photovoltaïque, chaque picot de tir laser étant creux et comportant une ouverture de forme conique. L'ouverture de forme conique peut avantageusement permettre d'assurer que le tir laser atteigne correctement la zone à souder, à savoir le conducteur de liaison au contact de la cellule photovoltaïque.

L'unité de soudure laser peut comporter au moins un premier système de vision permettant de positionner la tête laser selon une position prédéterminée.

En outre, la tête laser de l'unité de soudure laser peut être montée en translation par rapport à un bâti de l'unité de soudure laser, notamment montée en translation selon un premier axe horizontal, en translation selon un deuxième axe horizontal et en translation selon un troisième axe vertical, les premier, deuxième et troisième axes étant les axes d'un repère à trois axes.

De plus, l'unité de retournement peut comporter au moins un deuxième système de vision permettant de positionner le premier organe de préhension et/ou le deuxième organe de préhension selon une position prédéterminée.

Par ailleurs, le premier organe de préhension et/ou le deuxième organe de préhension de l'unité de retournement peuvent comporter respectivement des premiers moyens de préhension et/ou des deuxièmes moyens de préhension, notamment sous la forme de ventouses pour l'aspiration de ladite au moins une cellule photovoltaïque.

Le premier organe de préhension peut comporter des moyens de saisie dudit au moins un conducteur de liaison, notamment sous la forme d'une plaque poreuse pour l'aspiration dudit au moins un conducteur de liaison.

Le dispositif d'interconnexion peut encore comporter :
- une unité d'empilement de cellules photovoltaïques,
- une unité de prise, notamment un robot de prise, de ladite au moins une cellule photovoltaïque depuis l'unité d'empilement pour son transport vers l'unité de soudure laser, notamment vers une première zone de dépose de l'unité de soudure laser.

L'unité de prise peut comporter des moyens de prise de ladite au moins une cellule photovoltaïque, notamment sous la forme de ventouses pour l'aspiration de ladite au moins une cellule photovoltaïque.

En outre, l'unité de prise peut comporter un troisième système de vision permettant de positionner les moyens de prise selon une position prédéterminée.

Le dispositif d'interconnexion peut encore comporter une unité de convoyage, notamment un convoyeur à bande ou tapis roulant, comprenant une deuxième zone de dépose de ladite au moins une cellule photovoltaïque par l'unité de retournement et sur laquelle est formée ladite au moins une chaîne de cellules photovoltaïques.

Le dispositif d'interconnexion peut de plus comporter une unité d'acheminement de conducteurs de liaison vers l'unité de soudure laser.

Par ailleurs, l'invention a aussi pour objet, selon un autre de ses aspects, un procédé d'interconnexion par soudure laser de cellules photovoltaïques interconnectées par des conducteurs de liaison, mis en œuvre au moyen d'un dispositif d'interconnexion par soudure laser tel que défini précédemment.

Le procédé peut comporter les étapes successives suivantes :
- effectuer au moins un tir laser pour la fusion locale, ou encore fusion localisée, d'au moins un conducteur de liaison positionné sur l'une de la face avant et de la face arrière d'au moins une cellule photovoltaïque par le biais de la tête laser de l'unité de soudure laser,
- prendre ladite au moins une cellule photovoltaïque par le biais du premier organe de préhension de l'unité de retournement,
- pivoter ladite au moins une cellule photovoltaïque selon le premier angle de rotation d'au moins 180°,
- prendre ladite au moins une cellule photovoltaïque par le biais du deuxième organe de préhension de l'unité de retournement, le deuxième organe de préhension étant au contact de l'autre de la face avant et de la face arrière de ladite au moins une cellule photovoltaïque,
- effectuer au moins un tir laser pour la fusion locale, ou encore fusion localisée, d'au moins un conducteur de liaison positionné sur l'autre de la face avant et de la face arrière de ladite au moins une cellule photovoltaïque par le biais de la tête laser de l'unité de soudure laser.

De plus, le procédé peut comporter l'étape suivante :
- après préhension de ladite au moins une cellule photovoltaïque par le biais du deuxième organe de préhension, pivoter le deuxième organe de préhension selon un deuxième angle de rotation d'au moins 90° autour d'un axe vertical de préhension d'un montant vertical de l'unité de retournement sur lequel est monté le deuxième organe de préhension.

En outre, le procédé peut comporter l'étape suivante :
- positionner un masque de tir laser au contact des conducteurs de liaison et de la face avant ou de la face arrière de ladite au moins une cellule photovoltaïque avant d'effectuer ledit au moins un tir laser.

### BRÈVE DESCRIPTION DES FIGURES

D'autres avantages, buts et caractéristiques particulières de l'invention ressortiront de la description non limitative qui suit d'au moins un mode de mise en œuvre de la présente invention, en regard des figures annexées, sur lesquelles :
- la figure 1 représente, selon une vue en perspective partielle, un exemple de dispositif d'interconnexion par soudure laser de cellules photovoltaïques conforme à l'invention,
- la figure 2 représente, de manière isolée en perspective, l'unité de prise du dispositif d'interconnexion de la figure 1,
- les figures 3 à 7 représentent, de manière isolée en perspective partielle, l'unité de retournement du dispositif d'interconnexion de la figure 1 selon plusieurs positionnements illustratifs de son fonctionnement,
- la figure 8 représente, selon une vue en perspective partielle de détails, le positionnement d'une cellule photovoltaïque par l'unité de retournement du dispositif d'interconnexion de la figure 1 sur l'unité de convoyage,
- la figure 9 est un schéma illustrant les étapes d'un procédé d'interconnexion conforme à l'invention, mis en œuvre au moyen du dispositif d'interconnexion de la figure 1, et
- la figure 10 représente schématiquement une succession d'étapes mises en œuvre au niveau des zones de dépose du dispositif d'interconnexion de la figure 1.

Dans l'ensemble de ces figures, des références identiques peuvent désigner des éléments identiques ou analogues.

De plus, les différentes parties représentées sur les figures ne le sont pas nécessairement selon une échelle uniforme, pour rendre les figures plus lisibles.

### DESCRIPTION DÉTAILLÉE DE L'INVENTION

Il est à noter que les termes « vertical » et « horizontal » sont à comprendre ici selon leur sens usuel, et notamment par rapport au positionnement d'une chaîne S de cellules photovoltaïques 4 qui s'étend selon une direction horizontale sur une unité de convoyage 50 du dispositif d'interconnexion par soudure laser 100. De plus, un axe dit « vertical » est orthogonal à un axe dit « horizontal ». En outre, l'expression « mobile en translation selon un axe » peut également signifier ici « mobile en translation parallèlement à un axe ».

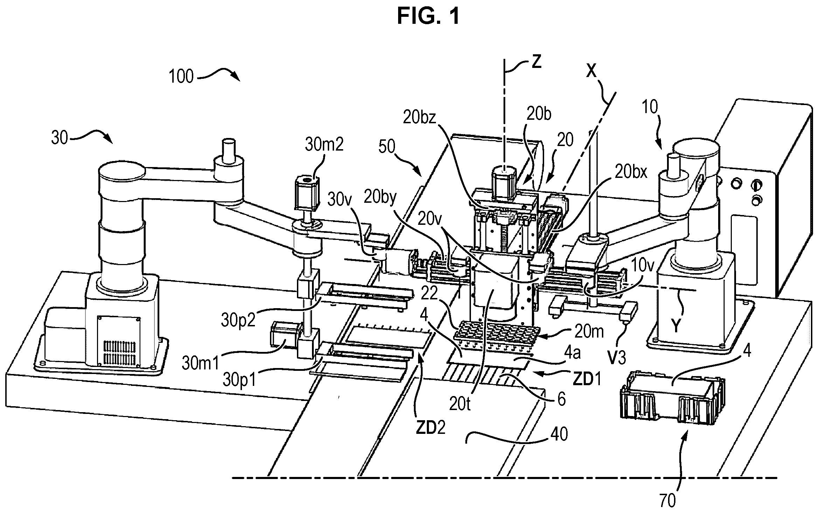

En référence aux figures 1 à 8, on va maintenant décrire un exemple de réalisation d'un dispositif d'interconnexion par soudure laser 100 conforme à l'invention, permettant l'interconnexion de plusieurs cellules photovoltaïques 4 pour former une chaîne S, ou « string » en anglais, par soudure impliquant une fusion locale ou localisée du ou des métaux purs à des températures élevées, notamment supérieures à 600°C, applicable à des cellules photovoltaïques 4 ne résistant pas à des températures trop importantes, notamment supérieures à 200°C. La réussite de cette fusion locale peut notamment dépendre de l'intensité, de la durée et de l'efficacité du tir laser. Elle peut notamment permettre une soudure sur une surface prédéterminée de part et d'autre d'un conducteur de liaison, par exemple une surface de l'ordre de 100 µm x 100 µm.

Le dispositif d'interconnexion 100 permet la soudure laser des conducteurs de liaison 6, typiquement des rubans ou des fils d'interconnexion, au contact de la face avant 4a, puis de la face arrière 4b, des cellules photovoltaïques 4 pour former une chaîne S de de cellules photovoltaïques 4.

Comme visible sur la figure 1, le dispositif d'interconnexion 100 comporte une unité d'empilement 70, ou stack, une unité de prise 10, une unité de soudure laser 20, une unité de convoyage 50, notamment un convoyeur à bande ou tapis roulant, une unité d'acheminement 40 de conducteurs de liaison 6 vers l'unité de soudure laser 20, et une unité de retournement 30.

L'unité d'empilement 70, ou stack de cellules photovoltaïques 4, comporte une pluralité de cellules photovoltaïques 4 empilées les unes sur les autres qui sont destinées à être interconnectées par le biais du dispositif d'interconnexion 100 conforme à l'invention.

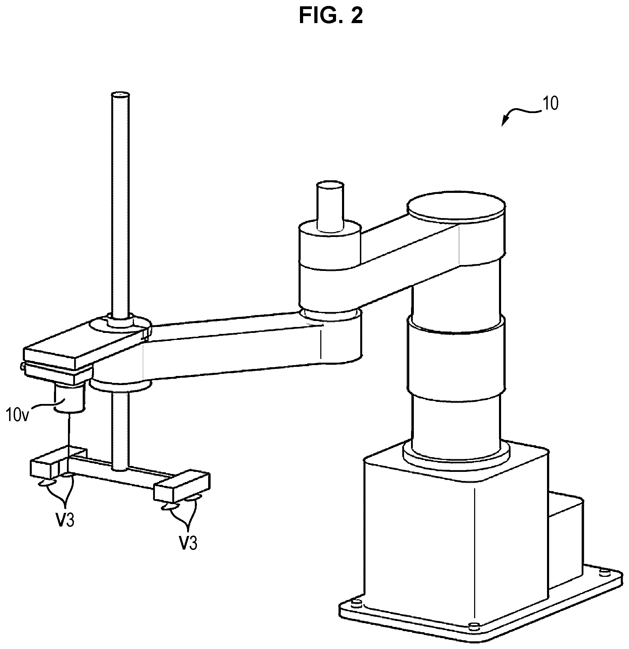

L'unité de prise 10 est représentée de manière isolée sur la figure 2. Elle correspond ici à un robot de prise permettant la préhension d'une cellule photovoltaïque 4 depuis l'unité d'empilement 70 pour l'acheminer vers une première zone de dépose ZD1, ou premier poste, au niveau de l'unité de soudure laser 20.

Pour cela, l'unité de prise 10 comporte des moyens de prise de la cellule photovoltaïque 4, ici sous la forme de ventouses V3 pour l'aspiration de la cellule photovoltaïque 4. Les ventouses V3 sont situées à l'extrémité d'un montant vertical portant par un bras robotisé.

De plus, l'unité de prise 10 comporte un troisième système de vision 10v, ici une caméra, qui permet de saisir correctement la cellule photovoltaïque 4 depuis l'unité d'empilement 70 et de la positionner correctement au niveau de la première zone de dépose ZD1.

Comme représenté sur la figure 1, l'unité de soudure laser 20 comporte une tête laser 20t configurée pour effectuer un ou plusieurs tirs laser en direction d'une cellule photovoltaïque 4 positionnée dans la première zone de dépose ZD1 ou positionnée dans la deuxième zone de dépose ZD2. De cette façon, une fusion locale ou localisée des conducteurs de liaison 6 positionnés sur la face avant 4a ou la face arrière 4b d'une cellule photovoltaïque 4 est réalisée.

Les tirs laser sont réalisés par la tête laser 20t au travers d'un masque de tir laser 20m qui permet à la fois le maintien en position des conducteurs de liaison 6 contre la face avant 4a ou la face arrière 4b de la cellule photovoltaïque 4 et, par le biais d'orifices au travers desquels passent les tirs laser, la soudre laser de manière localisée.

Le masque de tir laser 20m comporte avantageusement une pluralité de picots de tir laser 22 au travers desquels un tir laser est apte à être effectué pour la soudure par fusion locale ou localisée d'un conducteur de liaison 6 positionné sur la face avant 4a ou la face arrière 4b d'une cellule photovoltaïque 4, chaque picot de tir laser 22 étant creux et comportant une ouverture de forme conique.

En outre, l'unité de soudure laser 20 comporte un système de vision permettant de positionner correctement la tête laser 20t par rapport à la cellule photovoltaïque 4, ici deux premiers systèmes de vision 20v, de part et d'autre de la tête laser 20t, comportant chacun une caméra.

Avantageusement, la tête laser 20t de l'unité de soudure laser 20 est montée en translation selon les trois axes X, Y, Z d'un repère à trois axes par rapport à un bâti 20b de l'unité de soudure laser 20.

En particulier, la tête laser 20t est mobile en translation selon un premier axe horizontal X par rapport à un premier bâti 20bx, mobile en translation selon un deuxième axe horizontal Y par rapport à un deuxième bâti 20by et mobile en translation selon un troisième axe vertical Z par rapport à un troisième bâti 20bz. Des moteurs peuvent être prévus au niveau de extrémités de chacun des premier 20bx, deuxième 20by et troisième 20bz bâtis afin de mettre en mouvement la tête laser 20t.

Par ailleurs, le dispositif d'interconnexion 100 comporte une unité de retournement 30 de la cellule photovoltaïque 4, une fois réalisée la soudure laser sur la face avant 4a par le biais de la tête laser 20t. L'unité de retournement 30 permet également de positionner la cellule photovoltaïque 4 depuis la première zone de dépose ZD1 vers une deuxième zone de dépose ZD2 sur l'unité de convoyage 50.

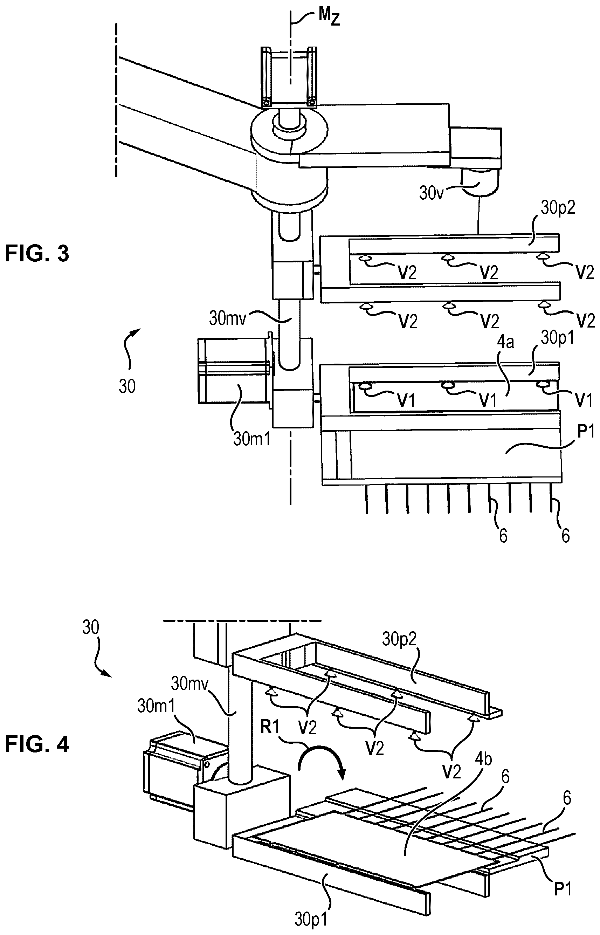

L'unité de retournement 30 est mieux visible sur les figures 3 à 8. L'unité de retournement 30 comporte tout d'abord un premier organe de préhension 30p1 pour la préhension de la face avant 4a de la cellule photovoltaïque 4 au niveau de la première zone de dépose ZD1 après la soudure laser des conducteurs de liaison 6 sur cette face avant 4a, avec des extrémités des conducteurs de liaison 6 qui dépassent de la face avant 4a en vue de l'interconnexion à une autre cellule photovoltaïque 4. Comme visible sur la figure 3, le premier organe de préhension 30p1 comporte ainsi des premiers moyens de préhension V1, ici sous la forme de ventouses V1 pour l'aspiration de la cellule photovoltaïque 4. Ces ventouses V1 sont présentes sous une plaque en forme de « U ». De plus, le premier organe de préhension 30p1 comporte également des moyens de saisie P1 des extrémités des conducteurs de liaison 6 qui dépassent de la face avant 4a de la cellule photovoltaïque 4. Ces moyens de saisie P1 sont ici sous la forme d'une plaque poreuse permettant l'aspiration des conducteurs de liaison 6, adjacente à la plaque en forme de « U ».

Par ailleurs, le premier organe de préhension 30p1 est apte à pivoter selon un premier angle de rotation R1, ici égal à 180°, comme représenté sur la figure 4. De cette façon, la cellule photovoltaïque 4 est retournée sur elle-même pour exposer sa face arrière 4b sur le dessus, dépourvue de conducteurs de liaison 6. Pour cela, l'unité de retournement 30 comporte ici un premier moteur 30m1 qui permet la rotation du premier organe de préhension 30p1 selon le premier angle R1, par rapport à un montant vertical 30mv s'étendant selon un axe vertical de préhension Mz.

En outre, l'unité de retournement 30 comporte un deuxième organe de préhension 30p2 pour la préhension de la face arrière 4b de la cellule photovoltaïque 4, après retournement à 180° du premier organe de préhension 30p1.

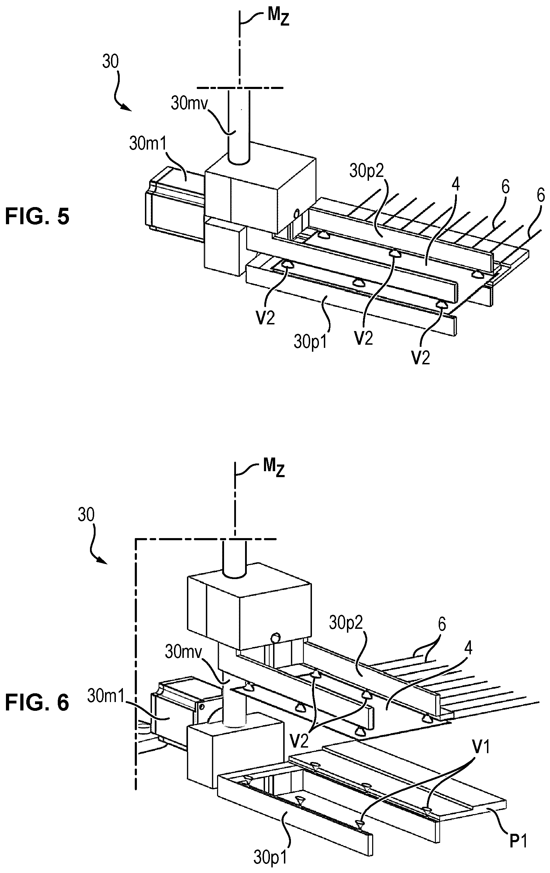

Le premier organe de préhension 30p1 et le deuxième organe de préhension 30p2 sont montés en superposition l'un par rapport à l'autre sur le montant vertical 30mv de l'unité de retournement 30, et le deuxième organe de préhension 30p2 est mobile en translation verticale par rapport au premier organe de préhension 30p1. Ainsi, comme visible sur la figure 5, le deuxième organe de préhension 30p2 vient coulisser le long du montant vertical 30mv pour venir au contact de la face arrière 4b de la cellule photovoltaïque 4. Le deuxième organe de préhension 30p2 comporte des deuxièmes moyens de préhension V2, ici sous la forme de ventouses V2 pour l'aspiration de la cellule photovoltaïque 4. Ces ventouses V2 sont par exemple situées sous une plaque en forme de « U », similaire à celle portant les ventouses V1.

La figure 6 illustre ensuite le déplacement du deuxième organe de préhension 30p2 vers le haut, une fois saisie la face arrière 4b de la cellule photovoltaïque 4.

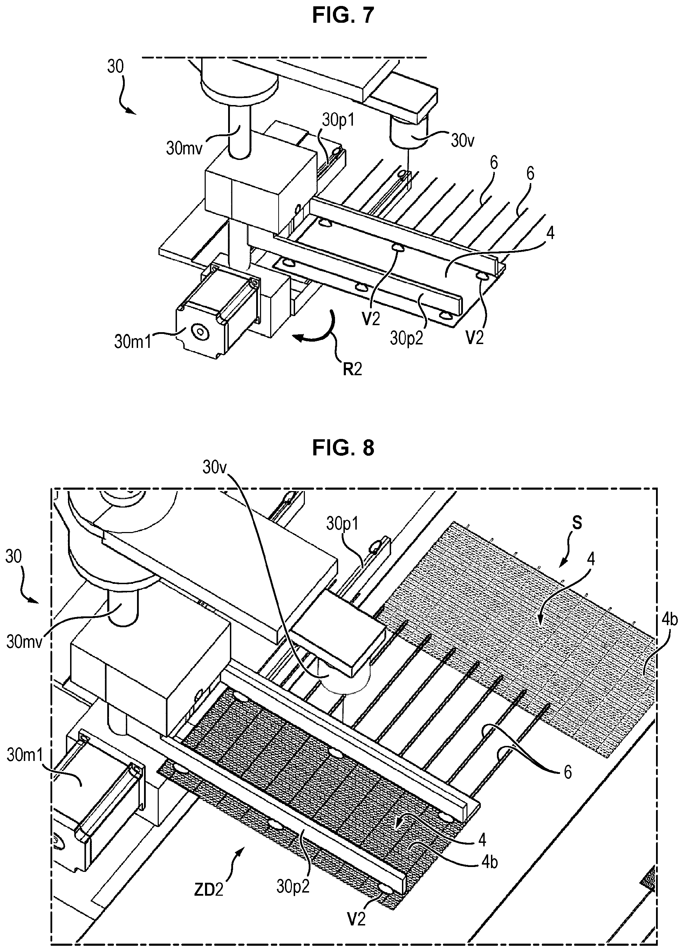

Une fois la préhension de la cellule photovoltaïque 4 réalisée par le deuxième organe de préhension 30p2, le deuxième organe de préhension 30p2 est mobile en rotation autour de l'axe vertical de préhension Mz selon un deuxième angle de rotation R2, ici égal à 90°, comme représenté sur la figure 7. Cette rotation permet de dégager la cellule photovoltaïque 4 de sa superposition avec le premier organe de préhension 30p1 en vue de la déposer sur la deuxième zone de dépose ZD2 au niveau de l'unité de convoyage 50.

Afin de permettre la rotation selon le deuxième angle de rotation R2, l'unité de retournement 30 comporte un deuxième moteur 30m2, visible sur la figure 1.

La figure 8 représente la dépose de la cellule photovoltaïque 4 par le deuxième organe de préhension 30p2 sur l'unité de convoyage 50 au niveau de la deuxième zone de dépose ZD2.

La cellule photovoltaïque 4 est déposée sur l'unité de convoyage 50 en réalisant un alignement avec la cellule photovoltaïque 4 déjà présente sur l'unité de convoyage 50 dans le but de former la chaîne S de cellules photovoltaïques 4, les extrémités des conducteurs de liaison 6 étant positionnées sur la face arrière 4b, exposée sur le dessus, de cette cellule photovoltaïque 4 déjà en place sur l'unité de convoyage 50. Alors, une soudure laser peut être réalisée dans cette deuxième zone de dépose ZD2, entre ces extrémités des conducteurs de liaison 6 et la face arrière 4b de la cellule photovoltaïque 4 déjà en place, en déplaçant l'unité de soudure laser 20 de sorte que la tête laser 20t soit superposée à celles-ci.

Il est à noter que l'unité de retournement 30 comporte en outre un deuxième système de vision 30v, ici sous la forme d'une caméra, permettant de positionner le premier organe de préhension 30p1 et le deuxième organe de préhension 30p2 correctement, notamment par rapport aux première ZD1 et deuxième ZD2 zones de dépose.

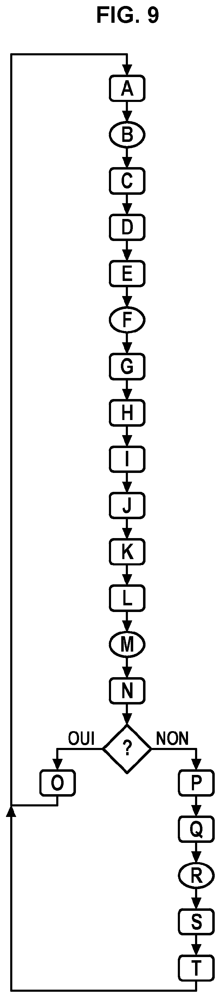

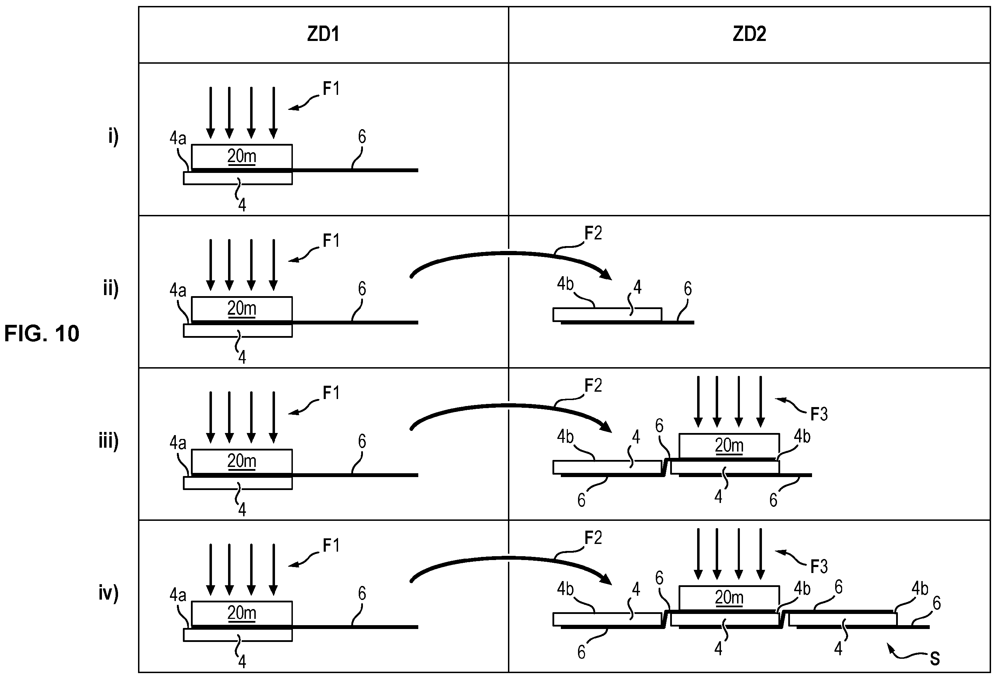

En référence aux figures 9 et 10, on va maintenant décrire un exemple de procédé d'interconnexion par soudure laser de cellules photovoltaïques 4 pour former une chaîne S de cellules photovoltaïques 4 interconnectées par des conducteurs de liaison 6, mis en œuvre au moyen du dispositif d'interconnexion par soudure laser 100 décrit auparavant.

Comme visible sur la figure 9, une étape A consiste en la prise d'une cellule photovoltaïque 4 depuis l'unité d'empilement 70 par le biais de l'unité de prise 10. Une détection de position est alors réalisée à l'aide du troisième système de vision 10v de l'unité de prise 10 (étape B) pour permettre de poser la cellule photovoltaïque 4 au niveau de la première zone de dépose ZD1 (étape C).

L'unité d'acheminement 40 permet ensuite la dépose de conducteurs de liaison 6, rubans ou fils, sur la face avant 4a de la cellule photovoltaïque 4 (étape D). L'étape E permet alors l'avancée de la tête laser 20t de l'unité de soudure laser 20, puis la détection de la position par le biais des premiers systèmes de vision 20v (étape F) permet d'être correctement situé en superposition de la face avant 4a de la cellule photovoltaïque 4 sur laquelle sont positionnés les conducteurs de liaison 6.

A ce stade, le procédé est alors représenté par la séquence i) de la figure 10 dans laquelle le une cellule photovoltaïque 4 est située dans la première zone de dépose ZD1 et prête à subir une soudure laser (schématisée par les flèches F1) au moyen du masque de tir laser 20m, et aucune cellule photovoltaïque n'est présente dans la deuxième zone de dépose ZD2.

Au cours de l'étape G, la soudure laser est réalisée par un mouvement de la tête laser 20t, notamment un mouvement selon les axes X et Y ou bien encore par un changement d'angle du tir laser, au travers du masque de tir laser 20m. Alors la tête laser 20t est reculée (étape H) et le premier organe de préhension 30p1 de l'unité de retournement 30 permet la prise de la cellule photovoltaïque 4 qui vient de subir la soudure laser (étape I).

La séquence ii) de la figure 10 illustre alors le fait que la cellule photovoltaïque 4 est retournée (schématisé par la flèche F2) à 180° de sorte à exposer sa face arrière 4b sur le dessus. Ce retournement correspond à l'étape J de la figure 9 et il est obtenu par le biais du pivotement selon le premier angle de rotation R1 du premier organe de préhension 30p1. Pendant ce temps, comme visible sur la séquence ii) de la figure 10, une autre cellule photovoltaïque 4 est placée dans la première zone de dépose ZD1 pour y subir une soudure laser comme décrite précédemment.

Une fois pivotée par le biais du premier organe de préhension 30p1, la cellule photovoltaïque 4 est prise par le deuxième organe de préhension 30p2 (étape K), puis une rotation du deuxième organe de préhension 30p2 est effectuée à 90° (étape L) et une détection de position par le biais du deuxième système de vision 30v (étape M) permet de déposer correctement la cellule photovoltaïque 4 sur l'unité de convoyage 50 (étape N).

Alors, il convient de s'interroger sur le fait de savoir si la cellule photovoltaïque 4 correspond ou non au début de la chaîne S à former, étape symbolisée par le symbole « ? » sur la figure 9.

Dans le cas où il s'agit du début de la chaîne S (cas « Oui » sur la figure 9), une étape O permet l'avancée de l'unité de convoyage 50, puis le procédé revient à son début au niveau de l'étape A.

Dans le cas où il ne s'agit pas du début de la chaîne S (cas « Non » sur la figure 9), une étape P consiste en la dépose de la cellule photovoltaïque 4 sur l'unité de convoyage 50 dans la deuxième zone de dépose ZD2. Alors, la tête laser 20t de l'unité de soudure laser 20 est avancée (étape Q) et son positionnement est ajusté par le biais des premiers systèmes de vision 20v (étape R). La soudure des conducteurs de liaison 6 sur la face arrière 4b de la cellule photovoltaïque 4 est réalisée au travers du masque de tir laser 20m, comme schématisé par les flèches F3 sur la figure 10 au niveau de la séquence iii). Alors, l'unité de convoyage 50 est avancée (étape T) et le procédé d'interconnexion se poursuit en revenant au niveau de l'étape A pour obtenir une chaîne S de cellules photovoltaïques 4 selon le même principe, comme visible sur la séquence iv) de la figure 10.

Bien entendu, l'invention n'est pas limitée aux exemples de réalisation qui viennent d'être décrits. Diverses modifications peuvent y être apportées par l'homme du métier.

## Revendications

1. Dispositif d'interconnexion par soudure laser (100) de cellules photovoltaïques (4) pour former au moins une chaîne (S) de cellules photovoltaïques (4) interconnectées par des conducteurs de liaison (6), **caractérisé en ce qu'**il comporte :
- une unité de soudure laser (20) comportant une tête laser (20t) configurée pour effectuer au moins un tir laser pour la fusion locale d'au moins un conducteur de liaison (6) positionné sur la face avant (4a) ou la face arrière (4b) d'au moins une cellule photovoltaïque (4),
- une unité de retournement (30) de ladite au moins une cellule photovoltaïque (4),
le dispositif étant **caractérisé en ce que** l'unité de retournement (30) comporte:
- un premier organe de préhension (30p1) pour la préhension de l'une de la face avant (4a) ou de la face arrière (4b) de ladite au moins une cellule photovoltaïque (4), le premier organe de préhension (30p1) étant apte à pivoter selon un premier angle de rotation (R1) d'au moins 180°,
- un deuxième organe de préhension (30p2) pour la préhension de l'autre de la face avant (4a) ou de la face arrière (4b) de ladite au moins une cellule photovoltaïque (4), le deuxième organe de préhension (30p2) étant mobile par rapport au premier organe de préhension (30p1).

2. Dispositif (100) selon la revendication 1, dans lequel le premier organe de préhension (30p1) et le deuxième organe de préhension (30p2) sont montés en superposition au moins partielle l'un par rapport à l'autre sur un montant vertical (30mv) de l'unité de retournement (30), s'étendant selon un axe vertical de préhension (Mz), le deuxième organe de préhension (30p2) étant mobile en translation verticale par rapport au premier organe de préhension (30p1).

3. Dispositif (100) selon la revendication 2, dans lequel le deuxième organe de préhension (30p1) est mobile en rotation autour de l'axe vertical de préhension (Mz), notamment selon un deuxième angle de rotation (R2) d'au moins 90°.

4. Dispositif (100) selon l'une des revendications précédentes, dans lequel l'unité de soudure laser (20) comporte un masque de tir laser (20m) au travers duquel la tête laser (20t) est apte à effectuer ledit au moins un tir laser, le masque de tir laser (20m) étant configuré pour maintenir en position ledit au moins un conducteur de liaison (6) contre la face avant (4a) ou la face arrière (4b) de ladite au moins une cellule photovoltaïque (4).

5. Dispositif (100) selon l'une quelconque des revendications précédentes, dans lequel la tête laser (20t) de l'unité de soudure laser (20) est montée en translation par rapport à un bâti (20b) de l'unité de soudure laser (20), notamment montée en translation selon un premier axe horizontal (X), en translation selon un deuxième axe horizontal (Y) et en translation selon un troisième axe vertical (Z), les premier (X), deuxième (Y) et troisième (Z) axes étant les axes d'un repère à trois axes.

6. Dispositif (100) selon l'une quelconque des revendications précédentes, dans lequel le premier organe de préhension (30p1) et/ou le deuxième organe de préhension (30p2) de l'unité de retournement (30) comportent respectivement des premiers moyens de préhension (V1) et/ou des deuxièmes moyens de préhension (V2), notamment sous la forme de ventouses (V1, V2) pour l'aspiration de ladite au moins une cellule photovoltaïque (4).

7. Dispositif (100) selon l'une quelconque des revendications précédentes, dans lequel le premier organe de préhension (30p1) comporte des moyens de saisie (P1) dudit au moins un conducteur de liaison (6), notamment sous la forme d'une plaque poreuse pour l'aspiration dudit au moins un conducteur de liaison (6).

8. Dispositif (100) selon l'une quelconque des revendications précédentes, dans lequel le dispositif d'interconnexion par soudure laser (100) comporte en outre :
- une unité d'empilement (70) de cellules photovoltaïques (4),
- une unité de prise (10), notamment un robot de prise (10), de ladite au moins une cellule photovoltaïque (4) depuis l'unité d'empilement (70) pour son transport vers l'unité de soudure laser (20), notamment vers une première zone de dépose (ZD1) de l'unité de soudure laser (20).

9. Dispositif (100) selon la revendication précédente, dans lequel l'unité de prise (10) comporte des moyens de prise (V3) de ladite au moins une cellule photovoltaïque (4), notamment sous la forme de ventouses (V3) pour l'aspiration de ladite au moins une cellule photovoltaïque (4).

10. Dispositif (100) selon l'une quelconque des revendications précédentes, dans lequel le dispositif d'interconnexion par soudure laser (100) comporte une unité de convoyage (50), notamment un convoyeur à bande ou tapis roulant, comprenant une deuxième zone de dépose (ZD2) de ladite au moins une cellule photovoltaïque (4) par l'unité de retournement (30) et sur laquelle est formée ladite au moins une chaîne (S) de cellules photovoltaïques (4).

11. Dispositif (100) selon l'une quelconque des revendications précédentes, dans lequel le dispositif d'interconnexion par soudure laser (100) comporte une unité d'acheminement (40) de conducteurs de liaison (6) vers l'unité de soudure laser (20).

12. Procédé d'interconnexion par soudure laser de cellules photovoltaïques (4) pour former au moins une chaîne (S) de cellules photovoltaïques (4) interconnectées par des conducteurs de liaison (6), mis en œuvre au moyen d'un dispositif d'interconnexion par soudure laser (100) selon l'une quelconque des revendications précédentes.

13. Procédé selon la revendication 12, dans lequel le procédé comporte les étapes successives suivantes :
- effectuer au moins un tir laser pour la fusion locale d'au moins un conducteur de liaison (6) positionné sur l'une de la face avant (4a) et de la face arrière (4b) d'au moins une cellule photovoltaïque (4) par le biais de la tête laser (20t) de l'unité de soudure laser (20),
- prendre ladite au moins une cellule photovoltaïque (4) par le biais du premier organe de préhension (30p1) de l'unité de retournement (30),
- pivoter ladite au moins une cellule photovoltaïque (4) selon le premier angle de rotation (R1) d'au moins 180°,
- prendre ladite au moins une cellule photovoltaïque (4) par le biais du deuxième organe de préhension (30p2) de l'unité de retournement (30), le deuxième organe de préhension (30p2) étant au contact de l'autre de la face avant (4a) et de la face arrière (4b) de ladite au moins une cellule photovoltaïque (4),
- effectuer au moins un tir laser pour la fusion locale d'au moins un conducteur de liaison (6) positionné sur l'autre de la face avant (4a) et de la face arrière (4b) de ladite au moins une cellule photovoltaïque (4) par le biais de la tête laser (20t) de l'unité de soudure laser (20).

14. Procédé selon la revendication 12 ou 13, dans lequel le procédé comporte l'étape suivante :
- après préhension de ladite au moins une cellule photovoltaïque (4) par le biais du deuxième organe de préhension (30p2), pivoter le deuxième organe de préhension (30p2) selon un deuxième angle de rotation (R2) d'au moins 90° autour d'un axe vertical de préhension (Mz) d'un montant vertical (30mv) de l'unité de retournement (30) sur lequel est monté le deuxième organe de préhension (30p2).

15. Procédé selon l'une quelconque des revendications 12 à 14, dans lequel le procédé comporte l'étape suivante :
- positionner un masque de tir laser (20m) au contact des conducteurs de liaison (6) et de la face avant (4a) ou de la face arrière (4b) de ladite au moins une cellule photovoltaïque (4) avant d'effectuer ledit au moins un tir laser.

## Patentansprüche

1. Vorrichtung (100) zur Verbindung von photovoltaischen Zellen (4) durch Laserschweißen, um mindestens eine Kette (S) aus photovoltaischen Zellen (4) zu bilden, die durch Verbindungsleiter (6) miteinander verbunden sind, **dadurch gekennzeichnet, dass** sie aufweist:
- eine Laserschweißeinheit (20), die einen Laserkopf (20t) aufweist, der so konfiguriert ist, dass er mindestens einen Laserschuss zum lokalen Schmelzen mindestens eines Verbindungsleiters (6) abgibt, der auf der Vorderseite (4a) oder der Rückseite (4b) mindestens einer photovoltaischen Zelle (4) positioniert ist,
- eine Wendeeinheit (30) für die mindestens eine photovoltaische Zelle (4), wobei die Vorrichtung **dadurch gekennzeichnet ist, dass** die Wendeeinheit (30) aufweist:
- ein erstes Greifelement (30p1) zum Ergreifen entweder der Vorderseite (4a) oder der Rückseite (4b) der mindestens einen photovoltaischen Zelle (4), wobei das erste Greifelement (30p1) um einen ersten Drehwinkel (R1) von mindestens 180° schwenkbar ist,
- ein zweites Greifelement (30p2) zum Ergreifen der anderen, entweder der Vorderseite (4a) oder der Rückseite (4b) der mindestens einen photovoltaischen Zelle (4), wobei das zweite Greifelement (30p2) relativ zum ersten Greifelement (30p1) bewegbar ist.

2. Vorrichtung (100) nach Anspruch 1, wobei das erste Greifelement (30p1) und das zweite Greifelement (30p2) mindestens teilweise übereinander im Verhältnis zueinander an einem vertikalen Ständer (30mv) der Wendeeinheit (30) angebracht sind, der sich gemäß einer vertikalen Greifachse (Mz) erstreckt, wobei das zweite Greifelement (30p2) relativ zum ersten Greifelement (30p1) vertikal translatorisch bewegbar ist.

3. Vorrichtung (100) nach Anspruch 2, wobei das zweite Greifelement (30p1) um die vertikale Greifachse (Mz) rotatorisch bewegbar ist, insbesondere um einen zweiten Drehwinkel (R2) von mindestens 90°.

4. Vorrichtung (100) nach einem der vorstehenden Ansprüche, wobei die Laserschweißeinheit (20) eine Laserschussmaske (20m) aufweist, durch die der Laserkopf (20t) den mindestens einen Laserschuss ausführen kann, wobei die Laserschussmaske (20m) so konfiguriert ist, dass sie den mindestens einen Verbindungsleiter (6) an der Vorderseite (4a) oder der Rückseite (4b) der mindestens einen photovoltaischen Zelle (4) in Position hält.

5. Vorrichtung (100) nach einem der vorstehenden Ansprüche, wobei der Laserkopf (20t) der Laserschweißeinheit (20) relativ zu einem Rahmen (20b) der Laserschweißeinheit (20) translatorisch angebracht ist, insbesondere translatorisch gemäß einer ersten horizontalen Achse (X), translatorisch gemäß einer zweiten horizontalen Achse (Y) und translatorisch gemäß einer dritten vertikalen Achse (Z) angebracht ist, wobei die erste (X), zweite (Y) und dritte (Z) Achse die Achsen eines dreiachsigen Koordinatensystems sind.

6. Vorrichtung (100) nach einem der vorstehenden Ansprüche, wobei das erste Greifelement (30p1) und/oder das zweite Greifelement (30p2) der Wendeeinheit (30) jeweils erste Greifmittel (V1) und/oder zweite Greifmittel (V2) aufweisen, insbesondere in Form von Saugnäpfen (V1, V2) zum Ansaugen der mindestens einen photovoltaischen Zelle (4).

7. Vorrichtung (100) nach einem der vorstehenden Ansprüche, wobei das erste Greifelement (30p1) Erfassungsmittel (P1) für den mindestens einen Verbindungsleiter (6), insbesondere in Form einer porösen Platte zum Ansaugen des mindestens einen Verbindungsleiters (6), aufweist.

8. Vorrichtung (100) nach einem der vorstehenden Ansprüche, wobei die Verbindungsvorrichtung durch Laserschweißen (100) ferner aufweist:
- eine Stapeleinheit (70) für photovoltaische Zellen (4),
- eine Aufnahmeeinheit (10), insbesondere einen Aufnahmeroboter (10), der mindestens einen photovoltaischen Zelle (4) aus der Stapeleinheit (70) für deren Transport zur Laserschweißeinheit (20), insbesondere zu einem ersten Ablagebereich (ZD1) der Laserschweißeinheit (20).

9. Vorrichtung (100) nach vorstehendem Anspruch, wobei die Aufnahmeeinheit (10) Aufnahmemittel (V3) für die mindestens eine photovoltaische Zelle (4) aufweist, insbesondere in Form von Saugnäpfen (V3) zum Ansaugen der mindestens einen photovoltaischen Zelle (4).

10. Vorrichtung (100) nach einem der vorstehenden Ansprüche, wobei die Verbindungsvorrichtung durch Laserschweißen (100) eine Fördereinheit (50) umfasst, insbesondere ein Förderband oder ein Laufband, das einen zweiten Ablagebereich (ZD2) für die mindestens eine photovoltaische Zelle (4) durch die Wendeeinheit (30) umfasst und auf dem die mindestens eine Kette (S) aus photovoltaischen Zellen (4) gebildet wird.

11. Vorrichtung (100) nach einem der vorstehenden Ansprüche, wobei die Verbindungsvorrichtung durch Laserschweißen (100) eine Einheit (40) zum Befördern von Verbindungsleitern (6) zu der Laserschweißeinheit (20) aufweist.

12. Verfahren zum Verbinden von photovoltaischen Zellen (4) durch Laserschweißen, um mindestens eine Kette (S) aus photovoltaischen Zellen (4) zu bilden, die durch Verbindungsleiter (6) miteinander verbunden sind, durchgeführt mittels einer Verbindungsvorrichtung durch Laserschweißen (100) nach einem der vorstehenden Ansprüche.

13. Verfahren nach Anspruch 12, wobei das Verfahren die folgenden aufeinanderfolgenden Schritte umfasst:
- Durchführen von mindestens einem Laserschuss zum lokalen Schmelzen mindestens eines Verbindungsleiters (6), der entweder auf der Vorderseite (4a) oder der Rückseite (4b) mindestens einer photovoltaischen Zelle (4) positioniert ist, anhand des Laserkopfes (20t) der Laserschweißeinheit (20),
- Aufnehmen der mindestens einen photovoltaischen Zelle (4) anhand des ersten Greifelements (30p1) der Wendeeinheit (30),
- Schwenken der mindestens eine photovoltaischen Zelle (4) um den ersten Drehwinkel (R1) von mindestens 180°,
- Aufnehmen der mindestens einen photovoltaischen Zelle (4) anhand des zweiten Greifelements (30p2) der Wendeeinheit (30), wobei das zweite Greifelement (30p2) mit der anderen, entweder mit der Vorderseite (4a) oder der Rückseite (4b) der mindestens einen photovoltaischen Zelle (4) in Kontakt ist,
- Durchführen von mindestens einem Laserschuss zum lokalen Schmelzen mindestens eines Verbindungsleiters (6), der auf der anderen, entweder auf der Vorderseite (4a) oder der Rückseite (4b) der mindestens einen photovoltaischen Zelle (4) positioniert ist, anhand des Laserkopfes (20t) der Laserschweißeinheit (20).

14. Verfahren nach Anspruch 12 oder 13, wobei das Verfahren den folgenden Schritt umfasst:
- nach dem Ergreifen der mindestens einen photovoltaischen Zelle (4) anhand des zweiten Greifelements (30p2), Schwenken des zweiten Greifelements (30p2) um einen zweiten Drehwinkel (R2) von mindestens 90° um eine vertikale Greifachse (Mz) eines vertikalen Ständers (30mv) der Wendeeinheit (30), an dem das zweite Greifelement (30p2) angebracht ist.

15. Verfahren nach einem der Ansprüche 12 bis 14, wobei das Verfahren den folgenden Schritt umfasst:
- Positionieren einer Laserschussmaske (20m) in Kontakt mit den Verbindungsleitern (6) und der Vorderseite (4a) oder der Rückseite (4b) der mindestens einen photovoltaischen Zelle (4), bevor der mindestens eine Laserschuss abgegeben wird.

## Claims

1. A laser-welding interconnection device (100) for photovoltaic cells (4) to form at least one string (S) of photovoltaic cells (4) interconnected by connecting conductors (6), **characterised in that** it comprises:
- a laser welding unit (20) comprising a laser head (20t) configured to perform at least one laser pulse to locally melt at least one connecting conductor (6) positioned on the front face (4a) or the rear face (4b) of at least one photovoltaic cell (4),
- a flipping unit (30) for said at least one photovoltaic cell (4), the device being **characterised in that** the flipping unit (30) comprises:
- a first gripping member (30p1) for gripping either the front face (4a) or the rear face (4b) of said at least one photovoltaic cell (4), the first gripping member (30p1) being capable of pivoting through a first angle of rotation (R1) of at least 180°,
- a second gripping member (30p2) for gripping the other of the front face (4a) or the rear face (4b) of said at least one photovoltaic cell (4), the second gripping member (30p2) being movable relative to the first gripping member (30p1).

2. A device (100) according to claim 1, wherein the first gripping member (30p1) and the second gripping member (30p2) are mounted at least partially one above the other on a vertical upright (30mv) of the turning unit (30), extending along a vertical gripping axis (Mz), the second gripping member (30p2) being movable in a vertical direction relative to the first gripping member (30p1).

3. A device (100) according to claim 2, wherein the second gripping member (30p1) is rotatable about the vertical gripping axis (Mz), in particular through a second angle of rotation (R2) of at least 90°.

4. A device (100) according to any one of the preceding claims, wherein the laser welding unit (20) comprises a laser firing mask (20m) through which the laser head (20t) is capable of performing said at least one laser firing, the laser firing mask (20m) being configured to hold said at least one connecting conductor (6) in position against the front face (4a) or the rear face (4b) of said at least one photovoltaic cell (4).

5. A device (100) according to any one of the preceding claims, in which the laser head (20t) of the laser welding unit (20) is mounted so as to be capable of translational movement relative to a frame (20b) of the laser welding unit (20), in particular mounted so as to be capable of translational movement along a first horizontal axis (X), along a second horizontal axis (Y) and along a third vertical axis (Z), the first (X), second (Y) and third (Z) axes being the axes of a three-axis coordinate system.

6. A device (100) according to any one of the preceding claims, in which the first gripping member (30p1) and/or the second gripping member (30p2) of the turning unit (30) comprise, respectively, first gripping means (V1) and/or second gripping means (V2), in particular in the form of suction cups (V1, V2) for suctioning said at least one photovoltaic cell (4).

7. A device (100) according to any one of the preceding claims, wherein the first gripping member (30p1) comprises means (P1) for gripping said at least one connecting conductor (6), in particular in the form of a porous plate for suction of said at least one connecting conductor (6).

8. A device (100) according to any one of the preceding claims, in which the laser-welding interconnection device (100) further comprises:
- a stacking unit (70) for photovoltaic cells (4),
- a gripping unit (10), in particular a gripping robot (10), for gripping said at least one photovoltaic cell (4) from the stacking unit (70) for transport to the laser welding unit (20), in particular to a first placement zone (ZD1) of the laser welding unit (20).

9. A device (100) according to the preceding claim, wherein the gripping unit (10) comprises gripping means (V3) for gripping said at least one photovoltaic cell (4), in particular in the form of suction cups (V3) for suctioning said at least one photovoltaic cell (4).

10. A device (100) according to any one of the preceding claims, wherein the laser-welding interconnection device (100) comprises a conveying unit (50), in particular a belt conveyor or roller conveyor, comprising a second placement zone (ZD2) for said at least one photovoltaic cell (4) via the flipping unit (30), and on which said at least one chain (S) of photovoltaic cells (4) is formed.

11. A device (100) according to any one of the preceding claims, wherein the laser-welding interconnection device (100) comprises a unit (40) for feeding connecting conductors (6) to the laser-welding unit (20).

12. A method for laser-welding photovoltaic cells (4) to form at least one string (S) of photovoltaic cells (4) interconnected by connecting conductors (6), carried out by means of a laser-welding interconnection device (100) according to any one of the preceding claims.

13. A method according to claim 12, wherein the method comprises the following successive steps:
- performing at least one laser pulse to locally melt at least one connecting conductor (6) positioned on either the front face (4a) or the rear face (4b) of at least one photovoltaic cell (4) by means of the laser head (20t) of the laser welding unit (20),
- gripping said at least one photovoltaic cell (4) by means of the first gripping member (30p1) of the flipping unit (30),
- rotating said at least one photovoltaic cell (4) by the first angle of rotation (R1) of at least 180°,
- gripping said at least one photovoltaic cell (4) by means of the second gripping member (30p2) of the turning unit (30), the second gripping member (30p2) being in contact with the other of the front face (4a) and the rear face (4b) of said at least one photovoltaic cell (4),
- performing at least one laser pulse to locally fuse at least one connecting conductor (6) positioned on either the front face (4a) or the rear face (4b) of said at least one photovoltaic cell (4) by means of the laser head (20t) of the laser welding unit (20).

14. A method according to claim 12 or 13, wherein the method comprises the following step:
- after gripping said at least one photovoltaic cell (4) by means of the second gripping member (30p2), rotating the second gripping member (30p2) through a second angle of rotation (R2) of at least 90° about a vertical gripping- x (Mz) of a vertical upright (30mv) of the turning unit (30) on which the second gripping member (30p2) is mounted.

15. A method according to any one of claims 12 to 14, wherein the method comprises the following step:
- positioning a laser firing mask (20m) in contact with the connecting conductors (6) and the front face (4a) or the rear face (4b) of said at least one photovoltaic cell (4) before carrying out said at least one laser firing.
